# FASCICULE DE BREVET EUROPEEN

(11) **EP 4 195 505 B1**
(45) Date de publication et mention de la délivrance du brevet: **15.07.2026**
(21) Numéro de dépôt: 22211791.3
(22) Date de dépôt: 06.12.2022
(51) Int. Cl.: H03H 11/12, H03H 11/50, H03H 7/03

(54) **FILTRE RADIOFRÉQUENCE ADAPTIF PRÉSENTANT UNE LINÉARITÉ AMÉLIORÉE**
ADAPTIVER FUNKFREQUENZFILTER MIT VERBESSERTER LINEARITÄT
ADAPTIVE RADIO FREQUENCY FILTER WITH IMPROVED LINEARITY

(30) Priorité: 07.12.2021 FR 2113057
(43) Date de publication de la demande: 14.06.2023
(73) Titulaire: THALES, 92400 Courbevoie (FR)
(72) Inventeur: CHAN WAI PO, Francis, 78851 ELANCOURT (FR); PETIT, Vincent, 78851 ELANCOURT (FR); LOUIS, Bruno, 78851 ELANCOURT (FR)
(74) Mandataire: Lavoix

(56) Documents cités:
- CN-A- 103 905 012
- US-A- 3 737 801
- US-A1- 2020 220 242
- VOROBEV EVGENII ET AL: "Active tunable inductor using non-Foster element", 2017 IEEE CONFERENCE OF RUSSIAN YOUNG RESEARCHERS IN ELECTRICAL AND ELECTRONIC ENGINEERING (EICONRUS), IEEE, 1 February 2017 (2017-02-01), pages 346 - 349, XP033088626, DOI: 10.1109/EICONRUS.2017.7910562
- "The Circuits and Filters Handbook", 1 January 2009, CRC PRESS, article WAI-KAI CHEN: "Continuous-Time Integrated Filters", pages: 16 - 1, XP055490855

## Description

L'invention concerne le domaine du traitement des signaux, notamment pour les radiocommunications et les systèmes radar.

L'invention concerne plus particulièrement des filtres radiofréquence adaptifs, aussi nommés filtres agiles, ou filtres reconfigurables. Les filtres adaptifs sont capables d'être reconfigurés pour changer en temps réel certaines de leurs propriétés, telles que la bande passante et la fréquence de coupure, en fonction des besoins.

Généralement, les filtres adaptifs sont construits soit à partir de filtres passifs, soit à partir de filtres actifs.

Les filtres passifs comportent des inductances passives, dont la valeur est fixe. Les inductances ne peuvent donc pas être modifiées, mais les performances et les propriétés du filtre peuvent être modifiées en temps réel en réglant des condensateurs variables qui sont associés aux inductances.

Cette solution présente néanmoins des inconvénients.

D'une part, les filtres passifs présentent un encombrement important, du fait de la taille des inductances passives. En effet, les filtres passifs ne sont généralement performants que sur une bande de fréquence relativement étroite. Pour disposer d'un filtre passif capable d'être utilisé sur une large bande de fréquence, il est souvent nécessaire lors de la conception de dupliquer des parties entières du filtre, chacune de ces parties de filtre étant optimisée sur une bande de fréquence donnée, le filtre devant ensuite être commuté par l'utilisateur pour sélectionner la partie de filtre correspondant aux besoins. On comprend que cette duplication de parties entières du filtre accroit l'encombrement et la complexité de fabrication du filtre.

D'autre part, pour des raisons pratiques, les filtres passifs sont généralement fabriqués au moyen de technologies d'intégration sur silicium. Toutefois, les inductances passives issues de ces technologies présentent souvent un facteur de qualité faible, ce qui contribue à des pertes d'insertion importantes.

Les filtres actifs comportent quant à eux des inductances actives variables, c'est à dire des circuits électroniques actifs simulant le comportement d'inductances, ces circuits pouvant comporter des éléments tels que des gyrateurs et/ou des amplificateurs.

Le brevet US 6184747 B1 décrit un exemple d'un filtre actif comportant un gyrateur.

Le document CN 103 905 012 décrit une conductance combinant une inductance active variable et une inductance passive fixe.

Le document « Active tunable inductor using non-Foster element » de E. Vorobev et al décrit une inductance active variable L_{neg} connectée à une inductance passive fixe Lₚₒₛ afin de réaliser un circuit avec une inductance à résistance négative.

Toutefois, les performances en linéarité des filtres actifs, par exemple quantifiées par le point d'interception du troisième ordre (IIP3), ne sont généralement pas suffisantes pour de nombreuses applications. De plus, la consommation électrique des inductances actives variables est généralement élevée, ce qui peut être rédhibitoire dans certaines applications.

C'est à ces inconvénients qu'entend plus particulièrement remédier l'invention en proposant un filtre radiofréquence adaptif amélioré.

A cet effet, un aspect de l'invention concerne un filtre radiofréquence adaptif selon la revendication 1.

Selon des aspects avantageux mais non obligatoires, un tel filtre radiofréquence est selon l'une quelconque des revendications 2 à 10.

L'invention sera mieux comprise et d'autres avantages de celle-ci apparaîtront plus clairement à la lumière de la description qui va suivre d'un mode de réalisation d'un filtre radiofréquence adaptif, donnée uniquement à titre d'exemple et faite en référence aux dessins annexés, dans lesquels :
- la figure 1 représente un exemple d'un filtre radiofréquence ;
- la figure 2 représente schématiquement une inductance composite variable faisant partie du filtre radiofréquence adaptif de la figure 1 et comportant une inductance fixe et une inductance variable ;
- la figure 3 représente un filtre radiofréquence adaptif selon un premier mode de réalisation de l'invention ;
- la figure 4 représente un filtre radiofréquence adaptif selon un deuxième mode de réalisation de l'invention ;
- la figure 5 illustre des performances d'un filtre radiofréquence adaptif conforme à l'invention.

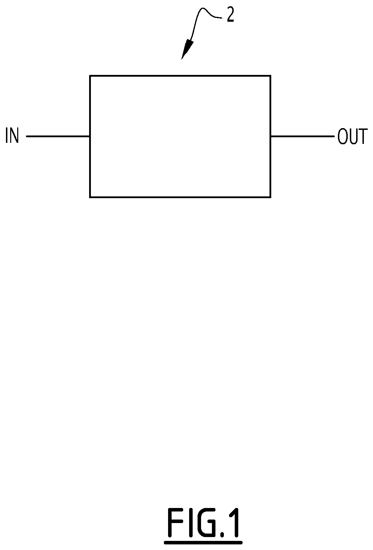

La figure 1 représente un exemple de filtre radiofréquence adaptif 2 comportant une entrée IN pour recevoir un signal radiofréquence et une sortie OUT. Par exemple, l'entrée IN comporte une ou plusieurs bornes d'entrée. La sortie OUT comporte une ou plusieurs bornes de sortie.

Le filtre radiofréquence adaptif 2 est un circuit électronique comportant une pluralité de composants électroniques, notamment des inductances.

Un aspect de l'invention vise notamment à proposer un filtre radiofréquence adaptif comportant une ou plusieurs inductances passives fixes combinées avec une ou plusieurs inductances actives variables.

Pour cela, on utilise avantageusement au moins une inductance composite variable comportant une inductance fixe et une inductance variable.

La combinaison des deux types d'inductances permet de bénéficier, dans un même filtre, d'une meilleure linéarité qu'en utilisant seulement des inductances actives, tout en réduisant l'encombrement et les pertes d'insertion liées aux inductances passives.

Cela permet également de régler plus finement l'inductance équivalente et ainsi de bénéficier d'une meilleure agilité, par exemple une plus grande facilité à reconfigurer le filtre.

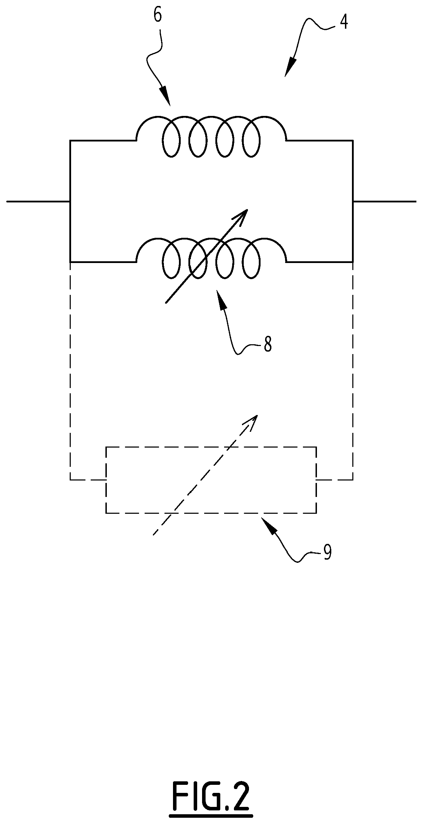

A titre d'illustration, la figure 2 représente une inductance composite variable 4 (ou inductance hybride) comportant une inductance passive fixe 6 et une inductance active variable 8, toutes deux connectées en parallèle.

L'inductance passive fixe 6 est, par exemple, un composant passif tel qu'une bobine.

L'ensemble 4 est, par exemple, une portion d'un filtre radiofréquence adaptif 2.

En variante, d'autres façons de coupler une inductance passive fixe 6 avec une inductance active variable 8 sont possibles. Par exemple, on peut construire une inductance composite variable dans laquelle l'inductance passive fixe 6 est connectée en série avec l'inductance active variable 8.

En pratique, pour former un filtre radiofréquence adaptif 2, on peut former plusieurs inductances composites variables 4, comportant chacun une ou plusieurs inductances passives fixes 6 couplées (en série, ou en parallèle, par exemple) avec une ou plusieurs inductances actives variables 8, ces inductances composites variables 4 étant ensuite connectées entre elles à la manière de modules.

Optionnellement, comme illustré sur la figure 2, l'inductance composite variable 4 peut être associée à une résistance négative 9, qui sera décrite plus en détail dans ce qui suit. Par exemple, la résistance négative est connectée en parallèle avec l'inductance active variable 8, d'autres façons d'associer la résistance négative 9 étant possibles en variante.

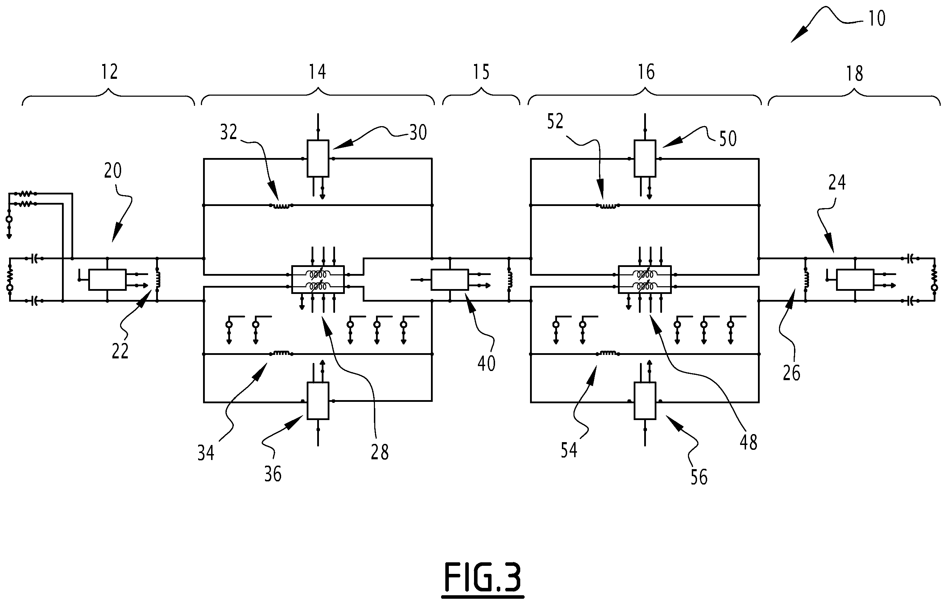

La figure 3 représente un filtre radiofréquence adaptif 10 selon un premier mode de réalisation de l'invention.

Dans ce mode de réalisation, le filtre 10 comporte plusieurs ensembles de composants, nommés inter-étages, parmi lesquels un premier inter-étage 12, un deuxième inter-étage 14, un troisième inter-étage 15, un quatrième inter-étage 16 et un cinquième inter-étage 18. Ces inter-étages sont par exemple connectés en série entre les bornes d'entrée et de sortie du filtre 10. Au moins une partie de ces ensembles de composants comporte une inductance composite variable 4.

L'inter-étage 12 comporte un condensateur variable 20, ici connecté en parallèle avec l'entrée du filtre 10, et une inductance passive fixe 22 (analogue à l'inductance 6), telle qu'une bobine, ici connectée en parallèle avec le condensateur variable 20.

Dans d'autres modes de réalisation, l'inductance passive fixe 22 pourrait être connectée, en série ou en parallèle, à au moins une inductance active variable pour former une inductance composite variable.

L'inter-étage 18 comporte un condensateur variable 24, ici connecté en parallèle avec la sortie du filtre, et une inductance passive fixe 26 (analogue à l'inductance 6), ici connectée en parallèle avec le condensateur variable 24.

Dans d'autres modes de réalisation, l'inductance passive fixe 26 pourrait être connectée, en série ou en parallèle, à au moins une inductance active variable pour former une inductance composite variable.

Par exemple, l'inter-étage 18 peut être construit de façon similaire ou symétrique par rapport à l'inter-étage 12, d'autres modes de réalisation étant néanmoins possibles en variante. Cependant, les valeurs de capacité et d'inductance des composants de l'inter-étage 18 ne sont pas forcément identiques à celles de l'inter-étage 12.

L'inter-étage 14 comporte au moins une inductance active variable, et de préférence deux inductances actives variables 8, ici comprises dans le module 28, les inductances actives variables du module 28 étant ici connectées en série avec l'inter-étage 12.

Par exemple, en configuration différentielle, le bloc 28 est équivalent à deux inductances variables 8 de même valeur : l'une connectée entre l'entrée positive et la sortie positive et l'autre entre l'entrée négative et la sortie négative du bloc 28.

L'inter-étage 14 comporte également un premier condensateur variable 30, une première inductance passive fixe 32, une deuxième inductance passive fixe 34 et un deuxième condensateur variable 36.

Par exemple, chacun de ces éléments 30, 32, 34 et 36 est connecté en parallèle des inductances actives variables 28.

Dans cet exemple, une première inductance composite variable de l'inter-étage 14 est formée par l'association de la première inductance passive fixe 32 et d'une des inductances actives variables du module 28. Une deuxième inductance composite variable de l'inter-étage 14 est formée par l'association de la deuxième inductance passive fixe 34 et de l'autre des inductances actives variables du module 28. Les deux inductances composites variables sont ici de même valeur.

L'association d'une inductance composite variable avec un condensateur variable permet de former un circuit résonnant LC variable.

L'inter-étage 14 est connecté en série avec l'inter-étage 16, ici par l'intermédiaire de l'inter-étage 15, ce dernier comportant un condensateur variable 40 et une inductance passive fixe, connectés en parallèle entre eux.

L'inter-étage 16 comporte au moins une inductance active variable 8 et de préférence deux inductances actives variables 8, ici comprises dans un module 48 (analogue au module 28), les inductances actives variables du module 48 étant ici connectées en série entre l'inter-étage 15 et l'inter-étage 18.

L'inter-étage 16 comporte également un premier condensateur variable 50, une première inductance passive fixe 52, une deuxième inductance passive fixe 54 et un deuxième condensateur variable 56.

Par exemple, chacun de ces éléments 50, 52, 54 et 58 est connecté en parallèle de l'inductance active variable 28. Par exemple, l'inter-étage 16, qui présente une configuration différentielle, est construit de façon analogue ou symétrique ou identique à l'inter-étage 14, d'autres modes de réalisation étant toutefois possibles en variante.

Dans cet exemple, une première inductance composite variable de l'inter-étage 16 est formée par l'association de la première inductance passive fixe 52 et d'une des inductances actives variables du module 48. Une deuxième inductance composite variable de l'inter-étage 16 est formée par l'association de la deuxième inductance passive fixe 54 et de l'autre des inductances actives variables du module 48.

Bien que cela ne soit pas illustré en détail sur la figure 2, le filtre 10 peut également comporter une ou plusieurs résistances négatives 9, cette ou ces résistances négatives 9 étant de préférence associées à au moins une des inductances actives variables, voire à chacune des inductances actives variables.

Le filtre 10 comporte également un système d'alimentation électrique, qui n'est pas représenté sur la figure 3, et qui est configuré, par exemple, pour alimenter électriquement des composants actifs du filtre 10, tels que les condensateurs variables et les inductances actives.

Le filtre 10 peut également comporter un système électronique de commande configuré pour modifier au moins un paramètre de fonctionnement du filtre, tel que la fréquence de coupure, ou la bande passante, ou le gain. Cette modification est par exemple réalisée en pilotant un ou plusieurs des éléments variables du filtre 10, tels que les condensateurs variables et/ou les inductances actives variables.

On comprendra que cet exemple de filtre 10 est donné à des fins d'illustration et qu'en variante, de nombreux autres filtres peuvent être construits de façon similaire, par exemple en combinant des ensembles de composants (inter-étages) de façon différente selon les propriétés désirées, au moins une partie de ces ensembles de composants comportant de préférence une inductance composite variable 4.

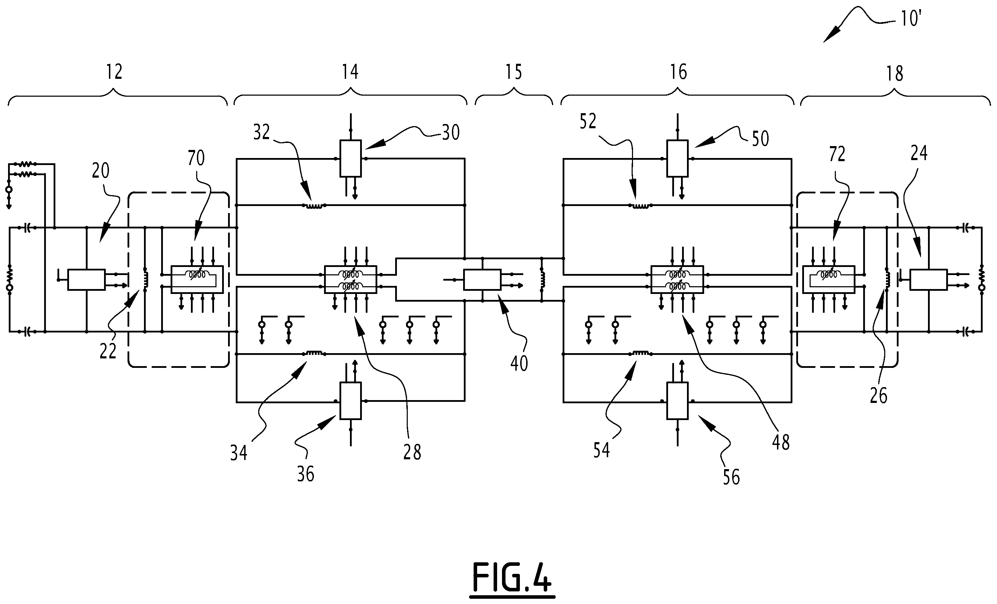

La figure 4 représente un filtre radiofréquence adaptif 10' selon un deuxième mode de réalisation de l'invention.

Le filtre radiofréquence 10' est largement identique au filtre radiofréquence 10, mis à part que le filtre radiofréquence 10' comporte deux inductances actives variables additionnelles 70 et 72 placées respectivement dans l'étage d'entrée 12 et dans l'étage de sortie 18, par exemple en étant connectée en parallèle de l'inductance passive fixe 22 ou 26.

En pratique, les inductances actives variables additionnelles 70 et 72 n'ont pas forcément les mêmes valeurs et peuvent être pilotées indépendamment, bien qu'elles puissent être identiques dans certains exemples.

Par exemple, chacune des inductances actives variables additionnelles 70 et 72 comporte une inductance variable réglable 8 telle que précédemment décrite.

Dans cet exemple, une inductance composite variable de l'inter-étage 12 est formée par l'association de l'inductance passive fixe 22 et d'une inductance active variable additionnelle (l'une des inductances du module 70). De façon analogue, une inductance composite variable de l'inter-étage 18 est formée par l'association de l'inductance passive fixe 26 et d'une inductance active variable additionnelle (par exemple l'une des inductances du module 72).

Mis à part ces différences, tout ce qui a été décrit en référence au filtre 10 de la figure 3 s'applique aussi au filtre radiofréquence 10' dans ce deuxième mode de réalisation.

De nombreuses autres variantes du filtre 10 ou 10' peuvent être construites en combinant des inductances passives fixes, des condensateurs variables et des inductances actives variables. Dans ces variantes, le nombre et la disposition des différents éléments constitutifs du filtre peuvent être différents de ceux des exemples présentés ci-dessus.

Dans de nombreux modes de réalisation, les condensateurs variables 30, 36, 50 et 56 sont réalisés en utilisant des diodes à capacité variable (par exemple des diodes varactors). On peut également utiliser des batteries de condensateurs comportant plusieurs condensateurs capables d'être sélectivement connectés ou déconnectés au moyen d'interrupteurs pilotables, tels que des transistors utilisés comme interrupteurs.

Les valeurs de capacité équivalente de ces condensateurs variables sont sélectionnées selon la bande de fréquence ciblée pour le fonctionnement du filtre. Cette sélection peut se faire de façon logicielle, par exemple par un système électronique de commande du filtre 10, afin de piloter les commandes au moyen d'un signal de commande

Par exemple, dans les cas d'une batterie de condensateurs, on peut piloter les interrupteurs numériquement avec une tension de commande appliquée sur une électrode de commande des interrupteurs (par exemple, sur la grille d'un transistor à effet de champ).

Dans de nombreux modes de réalisation, chaque inductance active réglable 8, 28, 48, 70, 72 comporte un circuit électronique actif simulant le comportement d'une inductance.

Ce circuit électronique peut, par exemple, comporter un ou plusieurs gyrateurs (« gyrator » en anglais), et/ou des amplificateurs, ou tout autre élément approprié.

De préférence, chaque inductance active réglable 8, 28, 48, 70, 72 comporte plusieurs gyrateurs connectés en série et/ou en parallèle, un condensateur variable étant associé à au moins une partie des gyrateurs, de préférence à chaque gyrateur.

Par exemple, les gyrateurs peuvent être construits à partir d'amplificateurs à transconductance, aussi nommés cellules à transconductance.

Chaque cellule à transconductance est associé à un condensateur variable Cₒᵤₜ placé en sortie, de telle façon que la valeur de l'inductance variable (Lvar) soit une fonction de la transconductance (gm) et de la capacité (Cₒᵤₜ) du condensateur correspondant.

Par exemple, chaque cellule à transconductance est un élément quadripôle qui comporte deux bornes d'entrée (par exemple, une borne positive et une borne négative) et deux bornes de sortie (par exemple, une borne positive et une borne négative).

Dans un premier exemple de construction, on peut former une inductance active variable 8 en construisant un gyrateur en associant deux cellules à transconductance connectées en parallèle entre elles entre des bornes d'entrée du circuit de l'inductance active et des bornes de sortie du circuit de l'inductance active, chacun de ces gyrateurs.

Par exemple, dans chacun des gyrateurs, la borne positive de la sortie de la deuxième cellule à transconductance est connectée à la borne négative de l'entrée de la première cellule à transconductance, et la borne négative de la sortie de la deuxième cellule à transconductance est connectée à la borne positive de l'entrée de la première cellule à transconductance. La borne négative de la sortie de la première cellule à transconductance est connectée à la borne négative de l'entrée de la deuxième cellule à transconductance, et la borne positive de la sortie de la première cellule à transconductance est connectée à la borne positive de l'entrée de la deuxième cellule à transconductance.

Un condensateur variable est connecté entre les première et deuxième bornes de sortie de chacune des cellules à transconductance. Selon des modes de réalisation, ces condensateurs peuvent être directement intégrés à chaque cellule à transconductance, ou ils peuvent être connectés à la sortie de chaque cellule à transconductance.

Afin de rendre l'inductance active variable, chacun de ces condensateurs Cₒᵤₜ est configuré de façon à être variable et réglable (c'est-à-dire que la valeur de capacité peur être modifiée par un utilisateur), par exemple en étant piloté électriquement par un système électronique de commande du filtre 10. A cette fin, chaque condensateur variable peut être réalisé comme précédemment décrit, par exemple en comportant des diodes à capacité variable contrôlables en tension, ou par tout moyen approprié.

Dans un deuxième exemple de construction, on peut former une inductance active variable 8 en connectant deux gyrateurs en série, entre des bornes d'entrée du circuit de l'inductance active et des bornes de sortie du circuit de l'inductance active, chacun de ces gyrateurs comportant l'association de deux cellules à transconductance connectées en parallèle entre elles, tel qu'expliqué précédemment.

Là encore, un condensateur variable est connecté entre les première et deuxième bornes de sortie de chacune des cellules à transconductance. Selon des modes de réalisation, ces condensateurs peuvent être directement intégrés à la cellule à transconductance, ou alternativement peuvent être connectés à la sortie de chaque cellule à transconductance.

De nombreux autres modes de réalisation sont possibles.

De préférence, chaque cellule à transconductance comporte une résistance négative réglable, ou convertisseur d'impédance négative, qui sert à compenser les pertes du filtre.

Par exemple, la valeur équivalente de la résistance négative, telle la résistance négative 9, est contrôlable en plaçant une résistance positive réglable en parallèle de la résistance négative. Dans un tel exemple, la résistance positive réglable peut être construite à partir d'un transistor à effet de champ (tel qu'un transistor MOSFET) fonctionnant en triode. Ainsi connecté, ce transistor fonctionne comme une résistance et sa valeur de résistance équivalente peut être réglée en variant la tension de la grille appliquée sur le transistor. D'autres implémentations sont néanmoins possibles en variante.

Les résistances négatives sont connues et ne sont pas décrites plus en détail. Un exemple de résistance négative est décrit dans l'article de C. Andriesei et al. « Negative resistance based tuning of an RF bandpass filter », Proceedings of the 4th European Conference on Circuits and Systems for Communications, ECCSC, Juillet 2008, Bucarest, Roumanie, DOI : 10.1109/ECCSC.2008.4611651. Cet exemple de construction n'est pas limitatif et d'autres implémentations sont possibles en variante.

Grâce à l'invention, en combinant une ou plusieurs inductances passives fixes avec une ou plusieurs inductances actives variables avec une ou plusieurs résistances négatives 9, on peut construire un filtre radiofréquence adaptif présentant une meilleure linéarité qu'en utilisant seulement des inductances actives, tout en réduisant l'encombrement et les pertes d'insertion liées à l'emploi des seules inductances passives.

Les éléments variables du filtre radiofréquence, tels que les inductances variables actives et les condensateurs variables, permettent au filtre radiofréquence de passer d'une bande de fréquence à une autre, sans avoir besoin de dupliquer des portions entières du circuit pour obtenir un fonctionnement satisfaisant sur de larges bandes de fréquence. Ainsi, le filtre radiofréquence est moins encombrant et moins complexe à concevoir que les filtres radiofréquence passifs connus.

Contrairement aux solutions à inductances passives connues, les pertes d'insertion peuvent avantageusement être réduites et contrôlées grâce aux résistances négatives intégrées aux inductances actives variables.

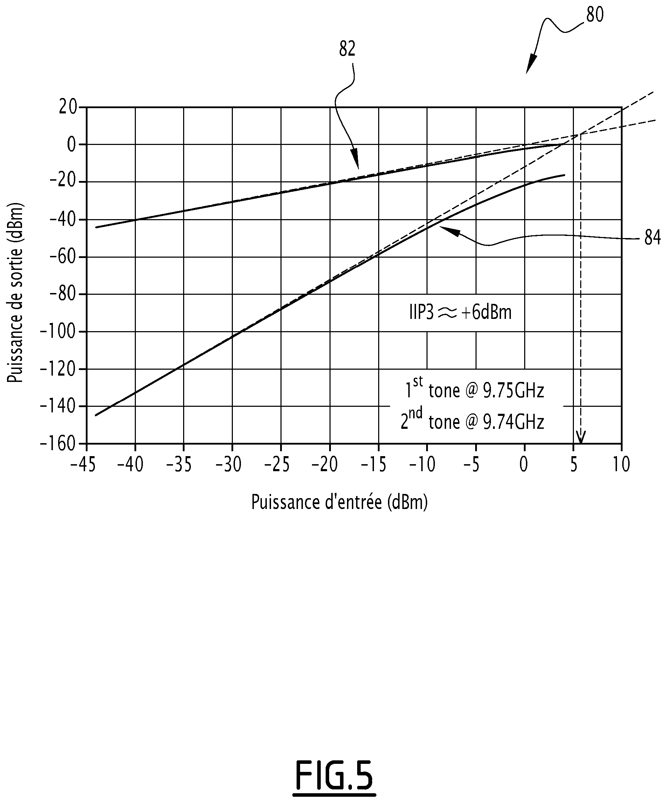

La figure 5 met en évidence des performances du filtre 10 de la figure 3, notamment pour illustrer l'amélioration des performances en linéarité du filtre 10, au moyen de mesures de distorsion d'intermodulation réalisées sur le filtre 10.

Sur le graphe 80, l'axe des abscisses correspond à la puissance d'entrée de signaux de test fournis au filtre 10, tandis que l'axe des ordonnées correspond à la puissance de sortie des signaux mesurés.

La première courbe 82 correspond à la fréquence fondamentale des signaux de test tandis que la deuxième courbe 84 correspond au produit l'intermodulation de troisième ordre. Les fréquences des signaux de test sont, dans cet exemple, égales à 9,75GHz (« 1^{st} tone ») et à 9,74 GHz (« 2^{nd} tone »), respectivement.

Dans ces exemples, la tension d'alimentation du filtre est égale à 1,2V, l'amplitude du courant d'alimentation du filtre est égale à 80mA, et le point d'interception du troisième ordre (IIP3) en entrée, extrapolé à partir des courbes 82 et 84, est égal à +6dBm.

D'autres essais, non illustrés, réalisés pour d'autres tensions d'alimentation et pour d'autres fréquences, ont permis de montrer que les performances en linéarité peuvent être encore plus améliorées, par exemple pour obtenir un point d'interception du troisième ordre (IIP3) allant jusqu'à plus de +20dBm.

Ces performances en linéarité et en consommation électrique sont meilleures que celles de filtres adaptifs classiques, tels que des filtres construits uniquement à partir d'inductances actives.

Des essais similaires menés sur des filtres adaptifs ayant une fonction similaire mais construits uniquement à partir d'inductances actives à base de gyrateurs ont montré que ces filtres actifs présentent, par comparaison, un point d'interception du troisième ordre égal à -10dBm et une consommation électrique de 160mA pour tout le filtre pour une tension d'alimentation de 1,2V, ce qui est le double de la consommation du filtre 10 dans l'exemple illustré ci-dessus.

Ainsi, associer judicieusement des inductances actives et des inductances passives pour former un filtre adaptif procure de meilleures performances, notamment en matière de linéarité et de consommation électrique, tout en réduisant la complexité de la conception du filtre.

## Revendications

1. Filtre radiofréquence adaptif (10 ; 10') comportant une entrée (IN), une sortie (OUT), au moins une inductance composite variable (4) comportant une inductance passive fixe (6, 22) et au moins une inductance active variable (8), l'inductance composite variable (4) étant connectée entre l'entrée et la sortie du filtre radiofréquence ; et ladite au moins une inductance active variable (8, 28, 48, 70) comportant un gyrateur et un condensateur variable (Cₒᵤₜ) connecté en sortie du gyrateur.

2. Filtre radiofréquence (10 ; 10') selon la revendication 1, lequel comporte en outre un condensateur variable associé à ladite au moins une inductance active variable (8).

3. Filtre radiofréquence (10 ; 10') selon la revendication 1 ou la revendication 2, lequel comporte en outre une résistance négative (9) associée à ladite au moins une inductance active variable.

4. Filtre radiofréquence (10 ; 10') selon l'une quelconque des revendications précédentes, lequel comporte un premier inter-étage (12) connecté à l'entrée du filtre, le premier inter-étage (12) comportant l'inductance passive fixe (22) connectée en série ou en parallèle avec l'inductance active variable pour former l'inductance composite variable.

5. Filtre radiofréquence (10 ; 10') selon la revendication 4, lequel comporte un autre inter-étage (18) connecté à la sortie du filtre, ledit inter-étage (18) comportant une autre inductance passive fixe (26) connectée en série ou en parallèle avec une autre inductance active variable pour former une autre inductance composite variable.

6. Filtre radiofréquence (10') selon la revendication 4 ou la revendication 5, dans lequel une inductance active variable (70, 72) est connectée en parallèle de l'inductance passive fixe (22, 26) pour former une inductance composite variable.

7. Filtre radiofréquence (10 ; 10') selon l'une quelconque des revendications précédentes, lequel comporte une inductance active variable (28, 48) connectée entre l'entrée et la sortie du filtre, ainsi qu'un premier condensateur variable (30, 50), une première inductance passive fixe (32, 52), une deuxième inductance passive fixe (34, 54) et un deuxième condensateur variable (36, 56) respectivement connectés en parallèle de l'inductance active variable (28, 48).

8. Filtre radiofréquence (10 ; 10') selon l'une quelconque des revendications précédentes, dans lequel le gyrateur est construit à partir d'amplificateurs à transconductance (gm).

9. Filtre radiofréquence (10 ; 10') selon la revendication 8, dans lequel chaque amplificateur à transconductance (gm) comporte une résistance négative réglable, pour compenser les pertes du filtre radiofréquence (10 ; 10').

10. Filtre radiofréquence (10 ; 10') selon l'une quelconque des revendications précédentes, lequel comporte un système électronique de commande configuré pour modifier au moins un paramètre de fonctionnement du filtre radiofréquence, tel que la fréquence de coupure, ou la bande passante, ou le gain.

## Patentansprüche

1. Adaptiver Hochfrequenzfilter (10; 10'), aufweisend einen Eingang (IN), einen Ausgang (OUT), mindestens eine variable Verbundinduktivität (4), die eine feste passive Induktivität (6, 22) und mindestens eine variable aktive Induktivität (8) aufweist, wobei die variable Verbundinduktivität (4) zwischen dem Eingang und dem Ausgang des Hochfrequenzfilters geschaltet ist; und wobei die mindestens eine variable aktive Induktivität (8, 28, 48, 70) einen Gyrator und einen variablen Kondensator (Cₒᵤₜ), verbunden mit dem Ausgang des Gyrators, aufweist.

2. Hochfrequenzfilter (10; 10') nach Anspruch 1, der ferner einen variablen Kondensator aufweist, welcher der mindestens einen variablen aktiven Induktivität (8) zugeordnet ist.

3. Hochfrequenzfilter (10; 10') nach Anspruch 1 oder Anspruch 2, der ferner einen negativen Widerstand (9) aufweist, welcher der mindestens einen variablen aktiven Induktivität zugeordnet ist.

4. Hochfrequenzfilter (10; 10') nach einem der vorhergehenden Ansprüche, der eine erste Zwischenstufe (12) aufweist, die mit dem Eingang des Filters verbunden ist, wobei die erste Zwischenstufe (12) die feste passive Induktivität (22) aufweist, die in Reihe mit oder parallel zu der variablen aktiven Induktivität geschaltet ist, um die variable Verbundinduktivität zu bilden.

5. Hochfrequenzfilter (10; 10') nach Anspruch 4, der eine weitere Zwischenstufe (18) aufweist, die mit dem Ausgang des Filters verbunden ist, wobei die Zwischenstufe (18) eine weitere feste passive Induktivität (26) aufweist, die in Reihe mit oder parallel zu einer weiteren variablen aktiven Induktivität geschaltet ist, um eine weitere variable Verbundinduktivität zu bilden.

6. Hochfrequenzfilter (10') nach Anspruch 4 oder Anspruch 5, wobei eine variable aktive Induktivität (70, 72) parallel zu der festen passiven Induktivität (22, 26) geschaltet ist, um eine variable Verbundinduktivität zu bilden.

7. Hochfrequenzfilter (10; 10') nach einem der vorhergehenden Ansprüche, der eine variable aktive Induktivität (28, 48), die zwischen dem Eingang und dem Ausgang des Filters geschaltet ist, sowie einen ersten variablen Kondensator (30, 50), eine erste feste passive Induktivität (32, 52), eine zweite feste passive Induktivität (34, 54) und einen zweiten variablen Kondensator (36, 56) aufweist, die jeweils parallel zu der variablen aktiven Induktivität (28, 48) geschaltet sind.

8. Hochfrequenzfilter (10; 10') nach einem der vorhergehenden Ansprüche, wobei der Gyrator aus Transkonduktanzverstärkern (gm) aufgebaut ist.

9. Hochfrequenzfilter (10; 10') nach Anspruch 8, wobei jeder Transkonduktanzverstärker (gm) einen einstellbaren negativen Widerstand aufweist, um die Verluste des Hochfrequenzfilters (10; 10') zu kompensieren.

10. Hochfrequenzfilter (10; 10') nach einem der vorhergehenden Ansprüche, der ein elektronisches Steuersystem umfasst, das konfiguriert ist, um mindestens einen Betriebsparameter des Hochfrequenzfilters, wie die Grenzfrequenz oder die Bandbreite oder die Verstärkung, zu ändern.

## Claims

1. An adaptive radio frequency filter (10; 10') comprising an input (IN), an output (OUT), at least one variable composite inductor (4) including a fixed passive inductor (6, 22) and at least one variable active inductor (8), the variable composite inductor (4) being connected between the input and the output of the radio frequency filter; and said at least one variable active inductor (8, 28, 48, 70) includes a gyrator and a variable capacitor (Cₒᵤₜ) connected to the output of the gyrator.

2. The radio frequency filter (10; 10') according to claim 1, wherein the filter further includes a variable capacitor associated with said at least one variable active inductor (8).

3. The radio frequency filter (10; 10') according to claim 1 or 2, wherein the filter further includes a negative resistor (9) associated with said at least one variable active inductor.

4. The radio frequency filter (10; 10') according to any of the preceding claims, wherein the filter further includes a first inter-stage (12) connected to the filter input, the first inter-stage (12) including the fixed passive inductor (22) connected in series or in parallel with the variable active inductor so as to form the variable composite inductor.

5. The radio frequency filter (10; 10') according to claim 4, wherein the filter further includes another inter-stage (18) connected to the filter output, said inter-stage (18) including another fixed passive inductor (26) connected in series or in parallel with another variable active inductor so as to form another variable composite inductor.

6. The radio frequency filter (10') according to claim 4 or 5, wherein a variable active inductor (70, 72) is connected in parallel with the fixed passive inductor (22, 26) so as to form a variable composite inductor.

7. The radio frequency filter (10; 10') according to any of the preceding claims, wherein the filter further includes a variable active inductor (28, 48) connected between the input and the output of the filter, as well as a first variable capacitor (30, 50), a first fixed passive inductor (32, 52), a second fixed passive inductor (34, 54) and a second variable capacitor (36, 56) respectively connected in parallel with the variable active inductor (28, 48).

8. The radio frequency filter (10; 10') according to any of the preceding claims, wherein the gyrator is built from transconductance amplifiers (gm).

9. The radio frequency filter (10; 10') according to claim 8, wherein each transconductance amplifier (gm) has an adjustable negative resistance for compensating the losses of the radio frequency filter (10; 10').

10. The radio frequency filter (10; 10') according to any of the preceding claims, wherein the filter further includes an electronic control system configured for changing at least one operating parameter of the radio frequency filter, such as the cut-off frequency, or the bandwidth, or the gain.
